# FASCICULE DE BREVET EUROPEEN

(11) **EP 1 277 281 B1**
(45) Date de publication et mention de la délivrance du brevet: **29.11.2006**
(21) Numéro de dépôt: 01925655.1
(22) Date de dépôt: 13.04.2001
(51) Int. Cl.: H03K 3/335

(54) **GENERATEUR DE RAMPE DE TENSION DE BALAYAGE RAPIDE ET CAMERA A FENTE UTILISANT UN TEL GENERATEUR**
GENERATOR FÜR SCHNELLE ABTASTRAMPENSPANNUNG UND DIESEN VERWENDENDE SCHLITZKAMERA
FAST SWEEP VOLTAGE RAMP GENERATOR AND STREAK CAMERA USING SAME

(30) Priorité: 17.04.2000 FR 0004909
(43) Date de publication de la demande: 22.01.2003
(73) Titulaire: COMMISSARIAT A L'ENERGIE ATOMIQUE, 75015 Paris (FR)
(72) Inventeur: SCHAAL, Alfred, F-91300 Massy (FR)
(74) Mandataire: Ilgart, Jean-Christophe
(86) Numéro de dépôt international: PCT/FR2001/001157
(87) Numéro de publication internationale: WO 2001/080424

(56) Documents cités:
- WO-A-98/26505
- US-A- 5 434 456

## Description

### DOMAINE TECHNIQUE

L'invention concerne un générateur de rampe de tension de balayage rapide et une caméra à fente utilisant un tel générateur.

### ÉTAT DE LA TECHNIQUE ANTÉRIEURE

Comme décrit dans le document référencé [1] en fin de description, les caméras à fente (ou "streak cameras" en langue anglaise), utilisées pour le diagnostic de phénomènes photoniques rapides (en lumière visible ou X) sont constituées d'une photocathode convertissant les photons en électrons, d'un système d'accélération et de déviation des électrons, et d'un système de reprise d'image.

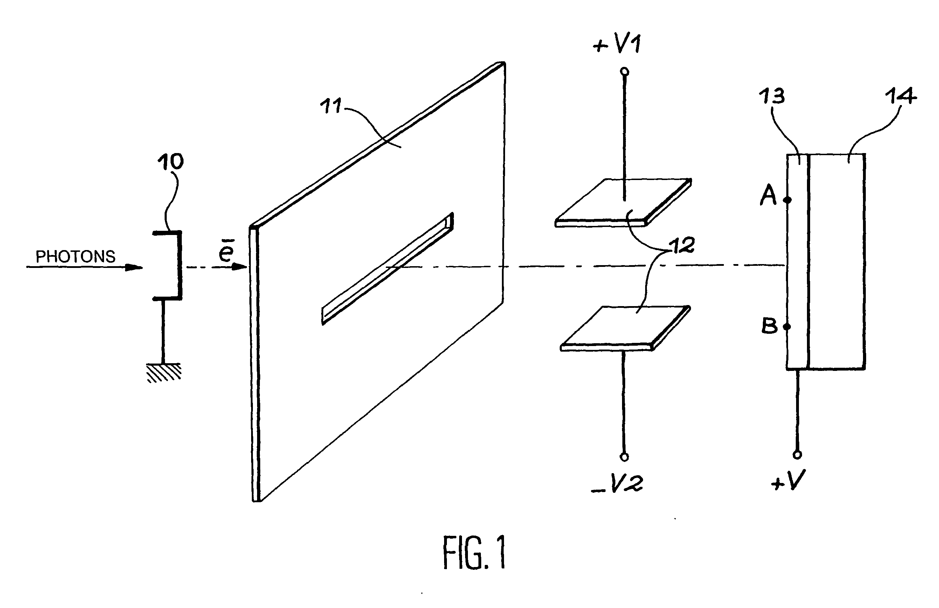

La figure 1 illustre schématiquement une telle caméra à fente qui comprend ainsi :
- une photocathode 10,
- une fente horizontale 11,
- deux plaques de déflexion 12,
- une anode 13,
- un système de reprise d'image 14.

Dans une telle caméra le phénomène de base, fonction du temps se trouve étalé sur l'écran de reprise 14. Il se trouve transformé en une fonction d'une distance. La mise en oeuvre d'une telle caméra nécessite l'utilisation d'un générateur de balayage qui délivre une rampe positive appliquée sur l'une des plaques 12 de déviation du faisceau d'électrons, soit +V1, et une rampe négative appliquée sur l'autre des plaques 12 de déviation : soit -V2. On obtient ainsi un mode commun autour du potentiel moyen de ces deux plaques 12.

La qualité des images obtenues in fine est directement liée à la qualité des rampes de balayage :
- linéarité,
- vitesse (en volts/nanoseconde),
- stabilité.

En ce qui concerne la technologie utilisée pour la réalisation de tels générateurs de rampes de balayage, les caméras peuvent être classées suivant la rapidité des phénomènes à observer.

C'est ainsi que l'on parle de :
- "caméra microseconde" : période de balayage > 1 µs,
- "caméra nanoseconde" : période de balayage < 1 µs,
- "caméra picoseconde" : 100 ps < période de balayage < 1 ns,
- "caméra femtoseconde" : période de balayage < 100 ps.

Pour obtenir un étalement (distance AB illustrée sur la figure 1) de 30 mm il faut une tension d'environ 400 Volts par plaque de déflexion 12 (ou par rampe).

Pour obtenir une telle tension, on doit utiliser les composants suivants :
- 400 V/µs ("caméra microseconde") : tubes à vide de type triode, ou transistors de type MOSFET,
- 400 V/ns ("caméra nanoseconde") : transistors de type avalanche montés en chaîne,
- 400 V/100 ps ("caméra picoseconde") : transistors de type avalanche en chaîne. Mais on génère dans ce cas une forte tension (par exemple 3 kVolts en 1 ns), dont on ne prend en compte qu'une partie linéaire de 400 Volts environ.

L'association de transistors à avalanche sous la forme d'une chaîne est ainsi décrite dans le document référencé [2].

Tous les générateurs de rampes de l'art connu ainsi obtenus sont en général compliqués, aux limites de la technologie, et de plus, bien souvent, à sortie haute impédance. Il en est ainsi des générateurs décrits dans le document référencé [3], qui envisage l'utilisation de chaînes de transistors à avalanche pour une application à des caméras optiques haute vitesse, et des générateurs décrits dans le document WO 98 26505.

La présente invention a pour objet de pallier les inconvénients des dispositifs de l'art connu en proposant un générateur délivrant une rampe positive et/ou une rampe négative rapides utilisant le principe des chaînes de transistors à avalanche.

### EXPOSÉ DE L'INVENTION

La présente invention concerne un générateur de rampe de tension de balayage rapide comprenant au moins une chaîne de N transistors bipolaires à avalanche en série et un ensemble de N éléments d'alimentation en série, N étant un nombre entier ≥2 par exemple égal à 8, l'émetteur et la base de chaque transistor étant reliés entre eux et étant également reliés au collecteur du transistor suivant dans la chaîne, un circuit d'entrée de génération d'une impulsion de tension relié à l'un des deux transistors situés en extrémité de la chaîne, caractérisé en ce que l'ensemble de N+1 éléments d'alimentation en série est formé par un ensemble de N+1 diodes zener en série entre une alimentation haute tension et la masse, en ce que le collecteur et l'émetteur de chaque transistor de la chaîne sont reliés d'une part respectivement à la cathode et à l'anode d'une diode zener correspondante au travers d'au moins une résistance, et d'autre part à la masse au travers d'un condensateur correspondant.

Avantageusement le générateur comprend deux chaînes de transistors bipolaires permettant de générer deux rampes de tension positive et négative.

Avantageusement, le circuit d'entrée de la première chaîne est relié au premier transistor de cette chaîne au travers d'un transformateur inverseur et d'un condensateur de manière à transmettre une impulsion positive reçue en entrée sur le collecteur de ce premier transistor. L'émetteur du dernier transistor de la première chaîne est relié à la sortie de la rampe positive au travers d'un condensateur. Le circuit d'entrée de la seconde chaîne est relié directement à l'émetteur du dernier transistor de la seconde chaîne de manière à lui transmettre une impulsion négative reçue en entrée. Le collecteur du premier transistor de la seconde chaîne est relié à la sortie de rampe négative au travers d'un condensateur. Une résistance est disposée entre l'alimentation haute tension et les diodes zener en série.

Avantageusement chaque résistance utilisée dans chaque chaîne est constituée de trois résistances de type composant monté en surface.

Avantageusement chaque condensateur dans les deux chaînes est du type « patch ».

Avantageusement les transistors à avalanche sont de type FMMT 415 de la société Zetex.

L'invention concerne également une caméra à fente utilisant un générateur à rampe tel que décrit ci-dessus.

Le générateur de rampe de l'invention utilisant une topologie particulière de circuit imprimé et des composants avalanche particuliers permet d'obtenir :
- une taille extrêmement réduite (<50 cm³),
- une alimentation unique (de +2500 Volts environ),
- une amplitude de 1000 Volts environ sur 50 ohms pour chacune des sorties,
- une pente de 10 Volts/picosecondes soit les 400 Volts en 40 picosecondes (application aux caméras femtoseconde).
- une stabilité au déclenchement (gigue) de 5 picosecondes.

Les transistors de type avalanche ZTX 415 ou FMMT 415 de la société ZETEX utilisés normalement et comme indiqué par le fabricant ne commutent qu'en 1,5 ns ; utilisés dans le générateur de l'invention, ils permettent d'obtenir des rampes de 0,1 à 0,13 ns.

### BRÈVE DESCRIPTION DES DESSINS

La figure 1 illustre schématiquement une caméra fente.

Les figures 2 et 3 illustrent le principe de fonctionnement du générateur de l'invention.

La figure 4 illustre un exemple de réalisation d'un générateur de rampe de tension de balayage rapide selon l'invention.

Les figures 5 à 9 représentent des courbes de fonctionnement du générateur de l'invention illustré sur la figure 4.

### EXPOSÉ DÉTAILLÉ DE MODES DE RÉALISATION PARTICULIERS

Le générateur de rampe de l'invention utilise des chaînes de transistors à avalanche. Un tel transistor avalanche est un transistor bipolaire qui lorsque la résistance base-émetteur est faible, présente une caractéristique courant collecteur-tension collecteur à pente négative. Il constitue un interrupteur très rapide dont la fermeture est commandée soit par la base, soit par dépassement de la tension limite du collecteur. Dans ce dernier cas, on relie base et émetteur. Le fonctionnement de ce transistor est alors analogue à celui d'un éclateur classique. Dans l'invention on ne s'intéresse qu'à ce deuxième cas.

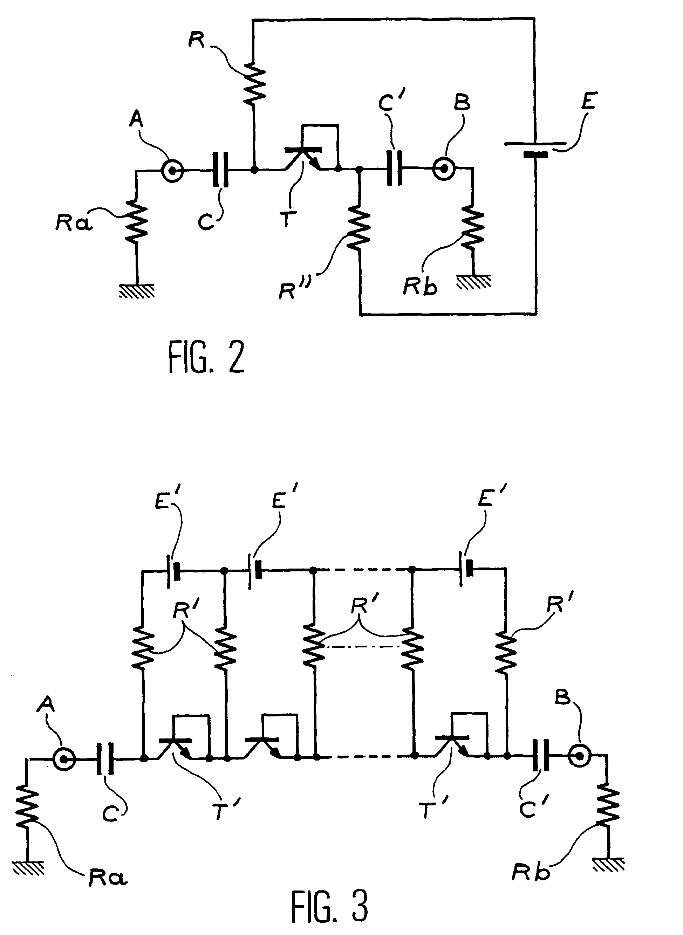

La figure 2 illustre le montage d'un tel transistor à avalanche T. La base et l'émetteur de ce transistor T sont reliés ensemble. Le collecteur de ce transistor est relié d'une part à la masse au travers d'une capacité C et d'une résistance Ra et d'autre part à la borne + d'une source continue E au travers d'une résistance R. L'émetteur de ce transistor est relié d'une part à la masse au travers d'une capacité C' et d'une résistance Rb et d'autre part à la borne - de la source E au travers d'une résistance R".

La source continue E polarise ce transistor T au travers des deux résistances R et R" à une valeur inférieure à sa tension de claquage.

L'ensemble des deux capacités C et C' se charge à cette valeur E.

Deux cas sont alors à considérer :
- on applique une impulsion positive au point A qui permet de dépasser la tension de claquage. Ceci a pour effet de faire commuter le transistor à avalanche T et de faire apparaître une rampe positive au point B par décharge des deux capacités C et C',
- on applique une impulsion négative au point B. Ceci a également pour effet de faire commuter le transistor à avalanche T, et de faire apparaître une rampe négative au point A par décharge des deux capacités C et C'.

L'amplitude des signaux fournis par un tel générateur à transistors avalanche est conditionnée par la tension limite du collecteur. Dans le cas où l'on veut avoir des amplitudes plus élevées, on utilise une chaîne de transistors T' comme représenté sur la figure 3.

Le transistor T de la figure 1 est alors remplacé par N transistors T' en série, chaque transistor T' ayant son collecteur relié à la borne + d'une source d'un ensemble de sources de tension E' disposées en série au travers d'une résistance R'. Chaque transistor T' est alimenté à la limite, comme le transistor T dans le montage de la figure 1.

De manière analogue au fonctionnement décrit pour le transistor unique T de la figure 1, une impulsion positive en A va produire une grande rampe positive au point B (N fois celle du transistor unique T). De même, une impulsion négative au point B va produire une grande rampe négative au point A. Dans les deux cas tous les transistors T' commutent en même temps.

Dans le cas où l'on désire obtenir à la fois une rampe positive et une rampe négative, on doit disposer de deux chaînes de transistors à avalanche, telles que celle représentée sur la figure 2 ; les entrée et sortie pour chaque rampe étant situées respectivement d'un côté et de l'autre : en A ou en B.

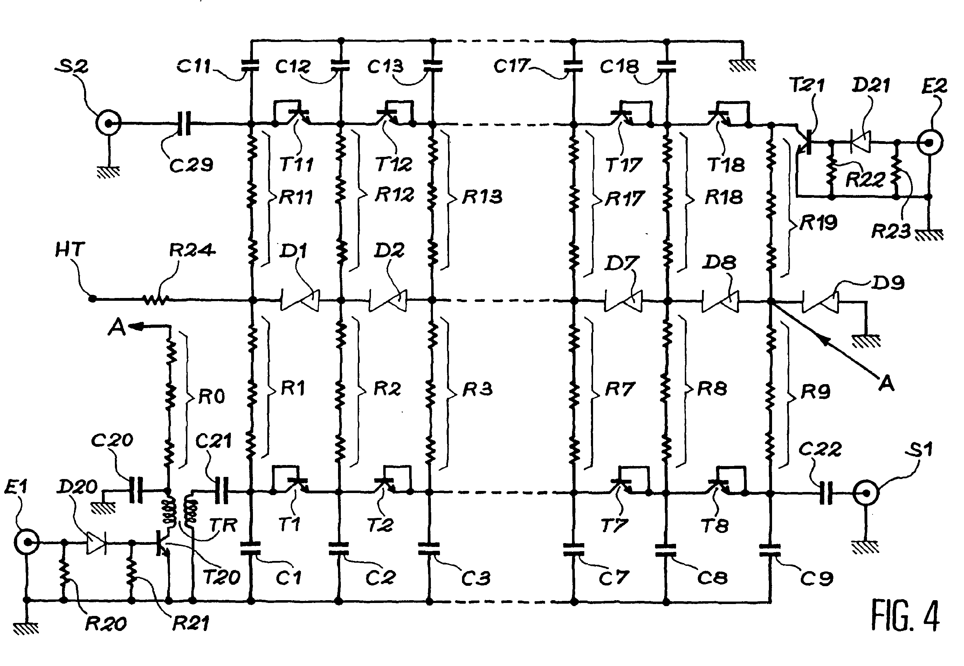

La figure 4 illustre le schéma d'un générateur de rampes positive et négative selon l'invention, réalisé à l'aide de deux chaînes de huit transistors à avalanche chacune.

Ce générateur comprend une première chaîne de N transistors bipolaires à avalanche de type NPN T1-T8, ici au nombre de 8, en série et une seconde chaîne de N transistors bipolaires à avalanche de type NPN T11-T18 en série et un ensemble de N+1 éléments d'alimentation en série, réalisés ici par des diodes zener D1-D9 en série entre une alimentation haute tension HT et la masse. Dans chaque chaîne l'émetteur et la base de chaque transistor T1-T8 et T11-T18 sont reliés entre eux et sont également reliés au collecteur du transistor suivant ; les collecteurs et les émetteurs de chaque transistor sont reliés à d'une part respectivement à la cathode et à l'anode d'une diode zener correspondante au travers d'au moins une résistance R1-R8 ou R11-R18, par exemple au travers de trois résistances de type composant monté en surface disposées sur le circuit imprimé du générateur, et d'autre part respectivement à la masse au travers d'un condensateur correspondant C1-C8 ; C11-C18.

Pour chaque chaîne un circuit d'entrée permettant de transmettre une impulsion de tension est relié à un transistor situé en extrémité de chaîne.

Le premier circuit d'entrée est formé d'un transistor T20 dont la base est relié à la masse au travers d'une résistance R21 en parallèle avec la résistance R20 en série avec une diode D20, dont l'émetteur est relié à la masse et dont le collecteur est relié à la cathode de la diode zener D9 au travers du primaire d'un transformateur TR en série avec une résistance R0. Il reçoit une impulsion positive en E1, et est utilisé pour appliquer une impulsion positive de commande sur le collecteur du premier transistor T1 de la première chaîne de transistors T1-T8.

Le second circuit d'entrée, formé de manière analogue d'un transistor T21 d'une diode D21 et de résistance R22 et R23, reçoit une impulsion positive en E2. Il est utilisé pour appliquer une impulsion négative de commande sur l'émetteur du dernier transistor T18 de la seconde chaîne de transistors T11-T18.

Le premier circuit d'entrée de la première chaîne T1-T8 est relié ainsi au premier transistor T1 de cette chaîne au travers du transformateur inverseur TR et d'un condensateur C21 de manière à transmettre une impulsion positive reçue en entrée E1 sur le collecteur de ce premier transistor T1. L'émetteur du dernier transistor T8 de la première chaîne est relié à la sortie de rampe positive S1 au travers d'un condensateur C22.

Le second circuit d'entrée de la seconde chaîne T11-T18 est, quant à lui, relié directement à l'émetteur du dernier transistor T18 de la seconde chaîne de manière à lui transmettre une impulsion négative reçue en entrée E2. Le collecteur du premier transistor T11 de la seconde chaîne est relié à la sortie de rampe négative S2 au travers d'un condensateur C29.

Une résistance R24 est disposée entre l'alimentation haute tension HT et les diodes zones D1 à D9 en série.

Une caractéristique très avantageuse du générateur de l'invention est que les tensions polarisant les transistors T1 à T9 et T11 à T18 des deux chaînes à partir de la tension d'alimentation positive unique HT, sont obtenues à l'aide des diodes zener D1 à D9.

Les condensateurs C1 à C8 et C11 à C18 sont avantageusement réalisés à l'aide de pastilles (ou "patches" en langue anglaise) sur le circuit imprimé du générateur de l'invention. Leur valeur diminue de C1 à C9 et de C20 à C13. Elles sont destinées à compenser les selfs parasites des deux chaînes de transistors.

Avantageusement, la configuration de ce générateur permet d'éviter toute perturbation entre les transistors T11-T18 et les transistors T1-T8.

Dans un exemple de réalisation on utilise les composants suivants :
Diodes
   D1 - D9 : diodes 270 V
   D20, D21 : 1N4148
Résistances
   R0 - R19 : trois résistances de 22000 Ω (CMS) chacune
   R20, R22 : 56 Ω
   R21, R23 : 68 Ω
   R24 : 15000 Ω, 1W
Condensateurs
   C1-C9 et C11-C18 : "patches" sur le circuit imprimé
   C20 : 470 pf, 300 V
   C21, C22, C23 : 470 pF, 2,5 kV céramique
Transistors
   T1-T8, T11-T18, T20, T21 : FMMT 415, Zetex SOT 23
Transformateur
   TR : transformateur inverseur
Alimentation continue
   HT : + 2460 V à + 2500 V
Entrées
   en E1, et en E2: impulsions 2V
Sorties
   S1 : rampe positive 1 kV/130 ps
   S2 : rampe négative 1 kV/130 ps

En technologie circuit imprimé, on peut réaliser un tel générateur ayant un format de 100 x 90 mm² pouvant être réduit à une taille de deux cartes de crédit.

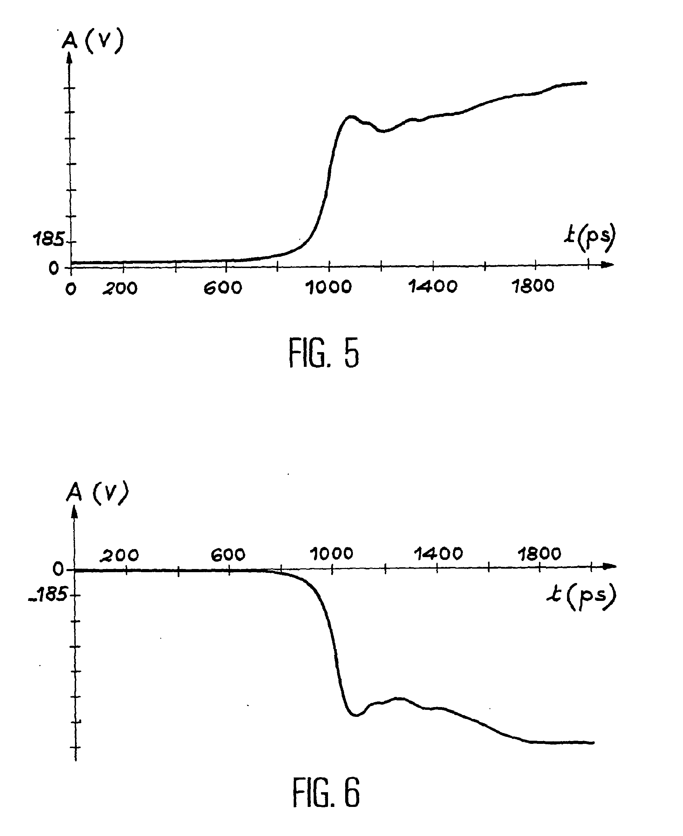

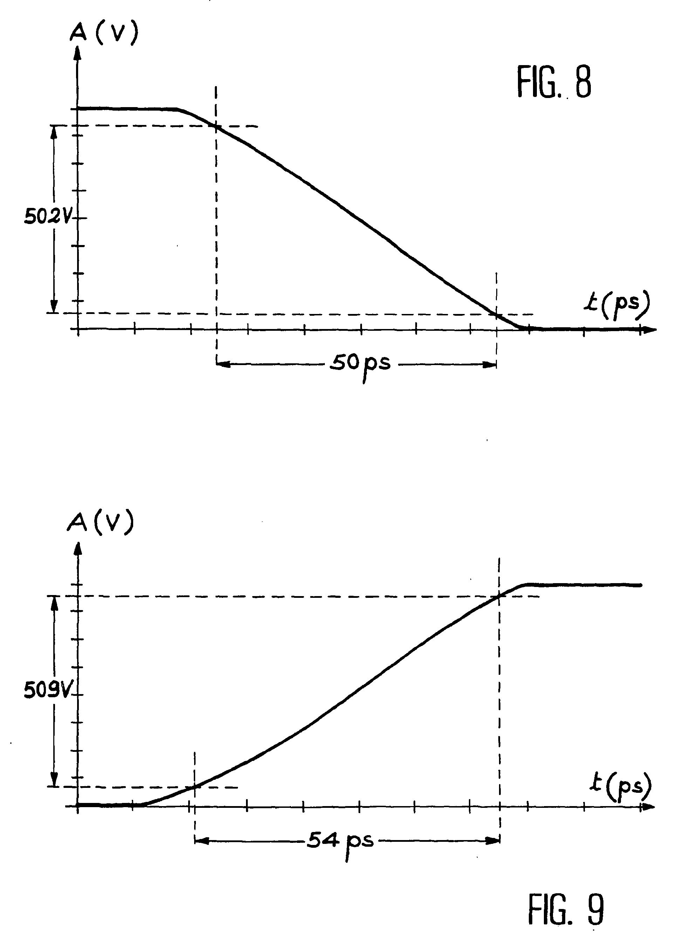

Le générateur de rampe de l'invention décrit ci-dessus permet d'obtenir des rampes positive et négative, telles que représentées sur les figures 5 et 6, de l'ordre de 1000 Volts avec des temps de montée de 130 picosecondes. Dans les zones de linéarité maximales, telles que représentées sur les figures 8 et 9, on obtient une variation d'environ 500 Volts en 50 picosecondes.

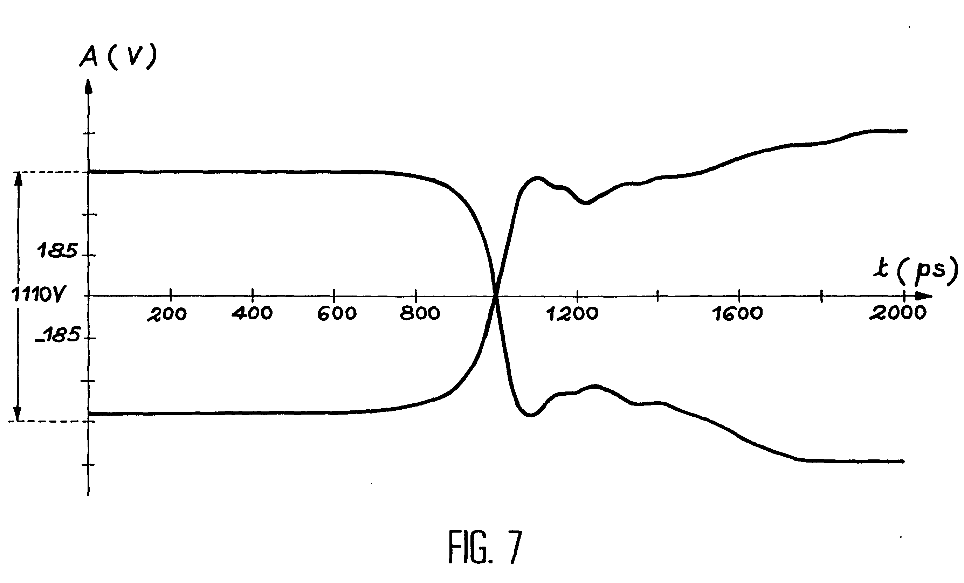

La figure 7 montre la symétrie des deux rampes illustrées sur les figures 5 et 6, obtenue en décalant chacune de celles-ci. Dans une utilisation caméra à fente on peut ainsi ajouter des tensions continues pour symétriser les courbes avec une tension zéro médiane.

Compte tenu du fait que la sortie est adaptée sur 50 ohms, le générateur de l'invention peut être déporté par rapport à la caméra, la liaison étant faite par des lignes de 50 ohms.

Ce générateur de rampes peut avantageusement être suivi par un circuit symétriseur de l'art connu de type Balun, qui joue également le rôle de transformateur d'impédance. Il est possible ainsi d'obtenir deux rampes, positive et négative, de 2 kV chacune sur 200 ohms. En outre, la symétrisation obtenue assure une plus grande sécurité de fonctionnement.

Pour obtenir des gammes de balayage plus lentes (1 ns, 2 ns...), il est possible de disposer, au niveau des plaques de déviation 12 de la caméra à fente, des filtres spéciaux de type gaussien entièrement passifs.

Ce générateur de rampes peut avantageusement être suivi par un circuit différentiateur. Il est possible ainsi d'obtenir deux impulsions fines, positive et négative, d'environ 50 picosecondes de largeur à mi-hauteur et 500 Volts d'amplitude (qui n'est limitée que par le nombre N de transistors). Appliquées à une antenne, ces impulsions permettent d'obtenir un système radar.

### REFERENCES

- [1] :: "Improvement in avalanche - transistor sweep circuitry for electroptic streak cameras" de S.W. Thomas, R.L. Griffith et W.R. McDonald (16e Congrès international, "High Speed Photographie and Photonics", Strasbourg, 27-31 août 1984).
- [2] :: "Avalanche transistors provides fast power transients" (Electronic engineering, Février 1991).
- [3] :: "The development of high peak power solid state pulse generators" de A.K.L. Dymoke-Bradshaw, J.D. Hares, P.A. Kellet et J. Westlake (Société Kentech, 26.5.1994).

## Revendications

1. Générateur de rampe de tension de balayage rapide comprenant au moins une chaîne de N transistors bipolaires à avalanche en série (T1-T8 ; T11-T18) et un ensemble de N+1 éléments d'alimentation en série, N étant un nombre entier ≥2, l'émetteur et la base de chaque transistor étant reliés entre eux et étant également reliés au collecteur du transistor suivant dans la chaîne, un circuit d'entrée de génération d'une impulsion de tension relié à l'un des deux transistors situés en extrémité de la chaîne, **caractérisé en ce que** l'ensemble de N+1 éléments d'alimentation en série est formé par un ensemble de N+1 diodes zener (D1-D9) en série entre une alimentation haute tension (HT) et la masse, **en ce que** le collecteur et l'émetteur de chaque transistor de la chaîne sont reliés d'une part respectivement à la cathode et à l'anode d'une diode zener (D1-D9) correspondante au travers d'au moins une résistance (R1-R9 ; R11-R19), et d'autre part à la masse respectivement au travers d'un condensateur correspondant (C1-C9 ; C11-C19).

2. Générateur selon la revendication 1, comprenant deux chaînes de transistors bipolaires permettant de générer deux rampes de tension positive et négative.

3. Générateur selon la revendication 2, dans lequel le circuit d'entrée de la première chaîne (T1-T8) est relié au premier transistor (T1) de cette chaîne au travers d'un transformateur inverseur (TR) et d'un condensateur (C21) de manière à transmettre une impulsion positive reçue en entrée (E1) sur le collecteur de ce premier transistor (T1).

4. Générateur selon la revendication 3, dans lequel l'émetteur du dernier transistor (T8) de la première chaîne est relié à la sortie de rampe positive (S1) au travers d'un condensateur (22).

5. Générateur selon la revendication 2, dans lequel le circuit d'entrée de la seconde chaîne (T11-T18) est relié directement à l'émetteur du dernier transistor (T18) de la seconde chaîne de manière à lui transmettre une impulsion négative reçue en entrée (E2).

6. Générateur selon la revendication 5, dans lequel le collecteur du premier transistor (T11) de la seconde chaîne est relié à la sortie de rampe négative (S2) au travers d'un condensateur (C29).

7. Générateur selon la revendication 1, dans lequel une résistance (R24) est disposée entre l'alimentation haute tension (HT) et les diodes zener (D1-D9) en série.

8. Générateur selon la revendication 1, qui est réalisé en technologie circuit imprimé et dans lequel chaque résistance (R0-R19) est constituée de trois résistances de type composant monté en surface.

9. Générateur selon la revendication 8, dans lequel chaque condensateur (C1-C9 ; C11-C19) est du type « patch ».

10. Générateur selon la revendication 1, dans lequel N est égal à 8.

11. Générateur selon la revendication 1, dans lequel les transistors à avalanche sont de type FMMT 415 de la société Zetex.

12. Caméra à fente utilisant un générateur à rampe selon l'une quelconque des revendications précédentes.

## Claims

1. Fast scanning voltage ramp generator comprising at least one chain of N two-pole avalanche transistors in series (T1-T8; T11-T18) and a set of N+1 power supply elements in series, where N is an integer number ≥ 2, the emitter and the base of each transistor being connected to each other and also being connected to the collector of the next transistor in the chain, an input circuit generating a voltage pulse connected to one of the two transistors at the end of the chain, **characterized in that** the set of N+1 power supply elements in series is formed by a set of N+1 zener diodes in series (D1-D9) between a high voltage (HV) power supply and the ground, and **in that** the collector and the emitter of each transistor in the chain are connected firstly to the cathode and to the anode of a corresponding zener diode (D1-D9) through at least one resistance (R1-R9; R11-R19), and secondly to the ground through a corresponding capacitor (C1-C9; C11-C19).

2. Generator according to claim 1, comprising two chains of two-pole transistors to generate two positive and negative voltage ramps.

3. Generator according to claim 2, in which the input circuit in the first chain (T1-T8) is connected to the first transistor (T1) in this chain through an inverter transformer (TR) and a capacitor (C21) so as to transmit a positive pulse received at the input (E1) on the collector of this first transistor (T1).

4. Generator according to claim 3, in which the emitter of the last transistor (T8) of the first chain is connected to the output of the positive ramp (S1) through a capacitor (22).

5. Generator according to claim 2, in which the input circuit to the second chain (T11 - T18) is directly connected to the emitter of the last transistor (T18) in the second chain to send it a negative pulse received as input (E2).

6. Generator according to claim 5, in which the collector of the first transistor (T11) in the second chain is connected to the output of the negative ramp (S2) through a capacitor (C29).

7. Generator according to claim 1, in which a resistance (R24) is placed between the high voltage power supply (HV) and the zener diodes (D1 - D9) in series.

8. Generator according to claim 1, which is made using the printed circuit technology and in which each resistance (R0 - R19) is composed of three surface mounted component type resistances.

9. Generator according to claim 8, in which each capacitor (C1 - C9; C11 - C19) is of the "patch" type.

10. Generator according to claim 1, in which N is equal to 8.

11. Generator according to claim 1, in which the avalanche transistors are of the FMMT 415 type made by the Zetex Company.

12. Streak camera using a ramp generator according to any one of the previous claims.

## Patentansprüche

1. Generator für schnelle Abtastrampenspannung, wenigstens eine Kette von N seriengeschalteten bipolaren Lawinentransistoren (T1-T8; T11-T18) und eine Menge von N+1 seriengeschalteten Versorgungselementen umfassend, wobei N eine ganze Zahl ≥2 ist und der Emitter und die Basis jedes Transistors miteinander verbunden sind und ebenfalls mit dem Kollektor des nächsten Transistors in der Kette verbunden sind, und eine Eingangsschaltung zur Erzeugung eines Spannungsimpulses umfassend, verbunden mit einem der beiden Endtransistoren der Kette,
**dadurch gekennzeichnet, dass** die Menge von N+1 seriengeschalteten Versorgungselementen gebildet wird durch eine Menge von N+1 Zenerdioden (D1-D9), seriengeschaltet zwischen einer Hochspannungsversorgung (HT) und der Masse, und **dadurch**, dass der Kollektor und der Emitter jedes Transistors der Kette einerseits durch jeweils wenigstens einen Widerstand (R1-R9; R11-R19) mit der Kathode und mit der Anode einer entsprechenden Zenerdiode (D1-D9) und andererseits durch jeweils einen entsprechenden Kondensator (C1-C9; C11-C19) mit der Masse verbunden sind.

2. Generator nach Anspruch 1, zwei Ketten bipolarer Transistoren umfassend, um zwei Rampen zu erzeugen, mit positiver und mit negativer Spannung.

3. Generator nach Anspruch 2, bei dem die Eingangsschaltung der ersten Kette (T1-T8) mit dem ersten Transistor (T1) dieser Kette durch einen Umkehrtransformator (TR) und einen Kondensator (C21) verbunden ist, um einen am Eingang (E1) erhaltenen positiven Impuls zum Kollektor dieses ersten Transistors (T1) zu übertragen.

4. Generator nach Anspruch 3, bei dem der Emitter des letzten Transistors (T8) der ersten Kette durch einen Kondensator (22) mit dem positiven Rampenausgang (S1) verbunden ist.

5. Generator nach Anspruch 2, bei dem die Eingangsschaltung der zweiten Kette (T11-T18) direkt mit dem Emitter des letzten Transistors (T18) der zweiten Kette verbunden ist, um ihm einen am Eingang (E2) erhaltenen negativen Impuls zu übertragen.

6. Generator nach Anspruch 5, bei dem der Kollektor des ersten Transistors (T11) der zweiten Kette durch einen Kondensator (C29) mit dem negativen Rampenausgang (S2) verbunden ist.

7. Generator nach Anspruch 1, bei dem ein Widerstand (R24) zwischen der Hochspannungsversorgung (HT) und den seriengeschalteten Zenerdioden (D1-D9) geschaltet ist.

8. Generator nach Anspruch 1, realisiert in Leiterplattentechnik, bei dem jeder Widerstand (R0-R19) durch drei Widerstände vom Typ Oberflächenmontagebauteil gebildet wird.

9. Generator nach Anspruch 8, bei dem jeder Kondensator (C1-C9; C11-C19) vom "Patch"-Typ ist.

10. Generator nach Anspruch 1, bei dem N gleich 8 ist.

11. Generator nach Anspruch 1, bei dem der Lawinentransistor vom Typ FMMT 415 der Firma Zetex ist.

12. Schlitzkamera mit einem Rampengenerator nach einem der vorangehenden Ansprüche.
